# EUROPÄISCHE PATENTSCHRIFT

(11) **EP 1 289 354 B1**
(45) Veröffentlichungstag und Bekanntmachung des Hinweises auf die Patenterteilung: **30.11.2005**
(21) Anmeldenummer: 01121061.4
(22) Anmeldetag: 01.09.2001
(51) Int. Cl.: H05K 3/00, H05K 3/46, B23K 26/18

(54) **Verfahren zum Herstellen von Löchern in einer Mehrlagenleiterplatte**
Process for manufacturing holes in a multilayer printed circuit board
Procédé de fabrication de trous dans un panneau à circuit imprimé multicouche

(43) Veröffentlichungstag der Anmeldung: 05.03.2003
(73) Patentinhaber: TRUMPF LASERTECHNIK GmbH, D-71254 Ditzingen (DE)
(72) Erfinder: Schwandt, Markus, 23617 Stockelsdorf (DE); Müllerschön, Oliver, 71229 Leonberg-Höfingen (DE)
(74) Vertreter: Kohler Schmid Möbus

(56) Entgegenhaltungen:
- EP-A- 0 948 247
- EP-A- 0 964 610
- WO-A-00/02426
- WO-A-00/57680
- WO-A-01/08457
- WO-A-01/15500
- DE-A- 3 103 986
- US-A- 5 841 099
- PATENT ABSTRACTS OF JAPAN vol. 2000, no. 22, 9. März 2001 (2001-03-09) & JP 2001 144411 A (MEC KK), 25. Mai 2001 (2001-05-25)
- PATENT ABSTRACTS OF JAPAN vol. 2000, no. 22, 9. März 2001 (2001-03-09) & JP 2001 135940 A (MATSUSHITA ELECTRIC WORKS LTD), 18. Mai 2001 (2001-05-18)
- PATENT ABSTRACTS OF JAPAN vol. 2000, no. 13, 5. Februar 2001 (2001-02-05) & JP 2000 286527 A (MATSUSHITA ELECTRIC WORKS LTD), 13. Oktober 2000 (2000-10-13)
- PATENT ABSTRACTS OF JAPAN vol. 2000, no. 09, 13. Oktober 2000 (2000-10-13) & JP 2000 153384 A (HITACHI VIA MECHANICS LTD), 6. Juni 2000 (2000-06-06)

## Beschreibung

Die Erfindung betrifft ein Verfahren zum Herstellen von Löchern in der die Außenseite einer Mehrlagenleiterplatte bildenden ersten Kupferschicht und in einer Dielektrikumschicht, welche die erste Kupferschicht von einer zweiten Kupferschicht trennt, mittels Laserstrahlung, wobei zur Abtragung der Dielektrikumschicht ein CO₂-Laserstrahl verwendet wird und wobei entweder die Intensität des CO₂-Laserstrahls höher als die zum Abtragen der ersten Kupferschicht erforderliche Schwellenintensität gewählt wird und das Loch in der ersten Kupferschicht und in der Dielektrikumschicht mit dem gleichen CO₂-Laserstrahl erzeugt wird oder wobei die Außenseite der ersten Kupferschicht mit einer Schicht, deren CO₂-Laserstrahlungsabsorption größer als die CO₂-Laserstrahlungsabsorption der Außenseite der ersten Kupferschicht ist, oder mit einer die CO₂-Laserstrahlungsabsorption erhöhenden Oberflächenbeschaffenheit versehen wird und dann ein Loch in der ersten Kupferschicht und in der Dielektrikumschicht mit dem gleichen CO₂-Laserstrahl erzeugt wird.

Ein derartiges Verfahren ist beispielsweise durch die WO 00/57680 A bekannt geworden.

Aus der DE 197 19 700 A1 ist ein Verfahren zum Herstellen von Sacklöchern (sogenannte Microvia-Bohrungen) in einer Mehrlagenleiterplatte (Multilayerplatine) bekannt, die eine Durchkontaktierung zwischen zwei durch eine Dielektrikumschicht voneinander getrennten Kupferschichten ermöglichen. Dazu wird mittels eines ersten Lasers ein Loch in die die Außenseite der Mehrlagenleiterplatte bildende erste Kupferschicht eingebracht, das bis in die darunterliegende Dielektrikumschicht reicht. Bei dem ersten Laser handelt es sich um einen Nd:YAG-Dauerstrichlaser mit einer zum Abtragen von Kupfer geeigneten Wellenlänge von 355 nm, der im Riesenimpulsbetrieb mit Pulsbreiten zwischen 1 ns und 1 µs betrieben wird. Mittels eines zweiten Lasers wird das Loch in der Dielektrikumschicht bis zur zweiten Kupferschicht vertieft. Bei dem zweiten Laser handelt es sich ebenfalls um einen Nd:YAG- oder einen CO₂-Laser mit einer im Vergleich zum ersten Laser größeren Wellenlänge im Bereich zwischen 1064 nm und 10600 nm, bei der die Laserstrahlung von Kupfer reflektiert wird. Der Durchmesser des vom zweiten Laser erzeugten Laserstrahls ist größer als im Falle des ersten Lasers, so daß die erste Kupferschicht mit dem darin ausgebildeten Loch als Blende wirkt und in der Dielektrikumschicht saubere Lochflanken erzeugt werden. Somit können die Anforderungen an die Fokussierbarkeit der Laserstrahlung und die Genauigkeit beim Positionieren der Mehrlagenleiterplatte erheblich gesenkt werden. Die zur Zeit erreichbaren Lochdurchmesser liegen zwischen 50 und 100 µm. Für dieses Verfahren ist allerdings eine Bohranlage mit zwei Nd:YAG-Lasern oder eine Hybridbohranlage mit einem CO₂- und einem Nd:YAG-Laser erforderlich. Nach dem Bohrvorgang wird in einem Galvanisierungsprozeß Kupfer in den Löchern abgeschieden und somit der elektrische Kontakt zwischen den beiden Kupferschichten, d.h. zwischen den beiden Leiterbahnebenen, hergestellt.

Es ist auch bekannt, das Loch in der ersten Kupferschicht in einem naß-chemischen Ätzprozeß zu erzeugen und dann dieses Loch mittels eines CO₂-Lasers bis zur zweiten Kupferschicht zu vertiefen. Dabei wirkt die erste Kupferschicht mit dem darin ausgeätzten Loch als Blende, so daß der Strahldurchmesser größer als das ausgeätzte Loch sein kann.

Bei dem aus der WO 00/57680 A bekannten Verfahren zum Herstellen einer Mehrlagenleiterplatte wird zuerst eine Kompositfolie mit einer Kupferfolie, die auf einer Trägerfolie befestigt ist, auf eine Kernplatte auflaminiert. Die Kupferfolie ist weniger als 10 µm dick und hat eine der Trägerfolie zugewandte Vorderseite und eine mit Harz beschichtete Rückseite. Die Trägerfolie wird von der Kupferfolie entfernt, um die Vorderseite der Kupferfolie frei zu legen. Dann werden mit einem CO₂-Laser Löcher durch die Kupferfolie und das Harz gebohrt, um Microvias zu bilden. Um die Absorption des CO₂-Laserlichts zu erhöhen, ist die Vorderseite der Kupferfolie aufgeraut oder oxidiert.

Schließlich ist auch ein Verfahren zum Herstellen von elektrischen Kontaktierungen bekannt, bei dem die Dielektrikumschicht auf die zweite Kupferschicht auflaminiert wird. Mittels eines CO₂-Lasers werden an den gewünschten Stellen Löcher in die freiliegende Dielektrikumschicht gebohrt, wobei die Anforderung an die Fokussierbarkeit hoch ist, da bei diesem Verfahren keine Maske zur Verfügung steht. Im nachfolgenden Galvanisierungsprozeß werden die elektrischen Kontaktierungen und die die Außenseite der Mehrlagenleiterplatte bildende erste Kupferschicht gemeinsam erzeugt.

Es ist die Aufgabe der Erfindung, bei einem Verfahren der eingangs genannten Art die Lochdurchmesser der in die erste Kupferschicht und in die Dielektrikumschicht gebohrten Löcher weiter zu reduzieren.

Diese Aufgabe wird erfindungsgemäß dadurch gelöst, daß die Schwellenintesität des CO₂-Laserstrahls nur innerhalb eines Strahldurchmessers kleiner als der Fokusdurchmesser des CO₂-Laserstrahls überschritten wird.

Der wesentliche Vorteil des erfindungsgemäßen Verfahrens besteht darin, daß der minimale Lochdurchmesser nicht durch den Fokusdurchmesser des CO₂-Laserstrahls, bei dem die maximale Intensität auf 1/e² abgefallen ist, sondern durch den Strahldurchmesser, innerhalb dessen die Intensität höher als die Schwellenintensität des Kupfers ist, bestimmt wird. Außerhalb dieses Strahldurchmessers wirkt die erste Kupferschicht als Blende für den Laserstrahl. Wird die Schwellenintensität daher nur in einem Strahldurchmesser kleiner als der Fokusdurchmesser überschritten, sind Lochdurchmesser kleiner als der Fokusdurchmesser möglich. Versuche haben gezeigt, daß mit einem CO₂-Laser mit einem Fokusdurchmesser von 90 µm Lochdurchmesser in der ersten Kupferschicht von ca. 50 µm erreicht werden. Diese Reduzierung wird durch die Schwellenintensität des Kupfers hervorgerufen, so daß auch bei zunehmender Miniaturisierung und damit weiterer Reduktion der Durchmesser von Microvia-Bohrungen der CO₂-Laser in Zukunft als effektives Werkzeug in der Multiplatinenherstellung zur Verfügung steht.

Um Microvia-Bohrungen mit einem Durchmesser von 90-100 µm zu erzielen, kann z.B. mit defokussiertem Strahl mit einem Durchmesser von 150 µm auf der Oberfläche gearbeitet werden. Die zum Kupferbohren erforderliche Energie beträgt in diesem Fall 22 mJ. Dies ist der rund 10-fache Wert verglichen mit dem Bohrprozeß in einer Dielektrikumschicht aus reinem Epoxydharz.

Vorzugsweise wird die Schicht auf der Außenseite der ersten Kupferschicht, z.B. im AlphaPrep-Verfahren, abgeschieden oder die Außenseite der ersten Kupferschicht durch Anätzen aufgerauht. Im ersteren Fall ist die Schicht bevorzugt eine metallorganische Beschichtung. Versuche haben gezeigt, daß durch eine Behandlung der Kupferoberfläche mit dem sogenannten AlphaPrep-Verfahren die CO₂-Laserstrahlungsabsorption auf der Kupferoberfläche erhöht wird. Beim AlphaPrep-Verfahren wird die Kupferoberfläche geätzt und gleichzeitig auf der geätzten Oberfläche eine braun-rote, mikroporige, metallorganische Schicht abgeschieden, die gute Hafteigenschaften für polymere Materialien bietet. Diese chemische Vorbehandlung wird standardmäßig als Haftvermittler vor dem Laminierungsprozeß der einzelnen Leiterbahnlagen in der Multilayerplatinenherstellung eingesetzt. Das AlphaPrep-Verfahren wird beispielsweise von der Fa. Würth Elektronik GmbH & Co. KG Leiterplattentechnik, D-74676 Niedernhall, angeboten.

Folgende Substanzen sind zum naßchemischen Ätzen von Kupfer besonders geeignet:
1. Eisen(III)-chlorid {FeCl₃}
2. Ammoniumpersulfat {Ammoniumperoxodisulfat, (NH₄)₂S₂O₈}
3. Natriumpersulfat {Natriumperoxodisulfat, Na₂S₂O₈}
4. Wasserstoffperoxid/Salzsäure {H₂O₂/HCl}.

Versuche haben gezeigt, daß das Anätzen der Kupferoberfläche ähnlich gute Ergebnisse hinsichtlich der CO₂-Laserstrahlungsabsorption ergibt wie die Beschichtung der Außenseite mit AlphaPrep.

Bevorzugt wird die Dielektrikumschicht bis zur zweiten Kupferschicht mittels des CO₂-Laserstrahls abgetragen.

Weitere Vorteile der Erfindung ergeben sich aus der Beschreibung und der Zeichnung. Ebenso können die vorstehend genannten und die noch weiter aufgeführten Merkmale erfindungsgemäß jeweils einzeln für sich oder zu mehreren in beliebigen Kombinationen Verwendung finden. Die gezeigte und beschriebene Ausführungsform ist nicht als abschließende Aufzählung zu verstehen, sondern hat vielmehr beispielhaften Charakter für die Schilderung der Erfindung.

Es zeigen:
- Fign. 1 bis 5: einen Querschnitt durch die Mehrlagenleiterplatte in unterschiedlichen Stadien des erfindungsgemäßen Verfahrens zum Herstellen eines Lochs in der Mehrlagenleiterplatte; und
- Fig. 6: das über den Strahlquerschnitt aufgetragene Intensitätsprofil eines das Loch in der Mehrlagenleiterplatte erzeugenden CO₂-Lasers.

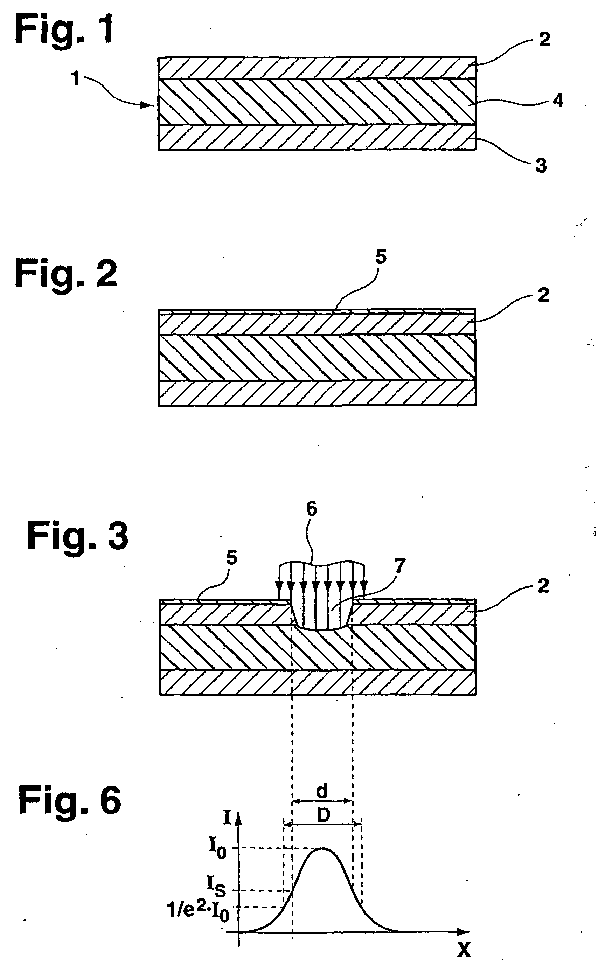

**Fig. 1** zeigt eine Mehrlagenleiterplatte **1** mit zwei Kupferschichten **2**, **3** und einer dazwischenliegenden Dielektrikumschicht **4** im Ausgangszustand vor der Einbringung eines Sackloches, das die Durchkontaktierung zwischen den Kupferschichten 2, 3 ermöglicht. Die Gesamtdicke der gezeigten Schichtenfolge beträgt etwa 50 bis 300 µm. Die Einbringung des Sackloches soll von der die Außenseite der Mehrlagenleiterplatte 1 bildenden ersten Kupferschicht 2 her erfolgen. Die Dielektrikumschicht 4 besteht aus Epoxydharz oder aus faserverstärktem Epoxydharz. An die zweite Kupferschicht 3 können sich weitere Dielektrikum- und Kupferschichten anschließen.

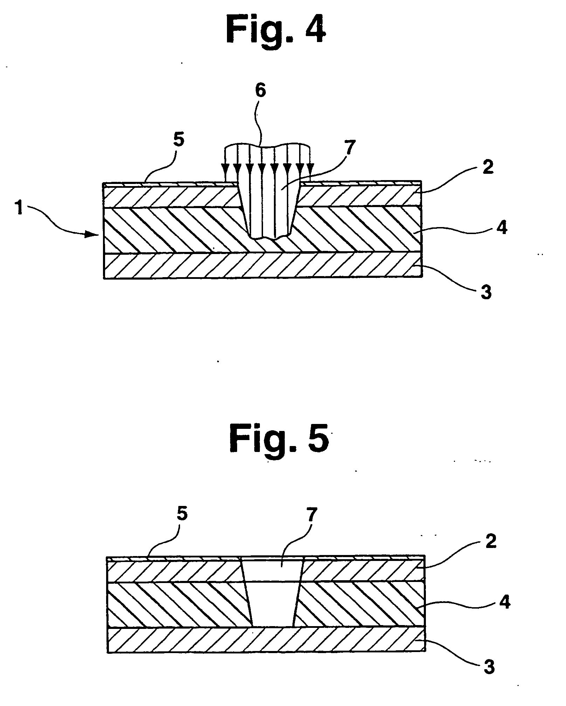

Wie **Fig. 2** zeigt, wird zunächst auf die Außenseite der ersten Kupferschicht 2 eine weitere Schicht 5 abgeschieden, deren CO₂-Laserstrahlungsabsorption größer als die CO₂-Laserstrahlungsabsorption der Außenseite der ersten Kupferschicht 2 ist. Dann wird mittels eines fokussierten CO₂-Laserstrahls 6 (Wellenlänge: 9,2 - 11,8 µm) ein Loch 7 in die erste Kupferschicht 2 (**Fig. 3**), dann weiter in die Dielektrikumschicht 4 eingebracht (**Fig. 4**) und bis zur zweiten Kupferschicht 3 vertieft (**Fig. 5**).

Bei der aufgebrachten weiteren Schicht 5 handelt es sich um eine braun-rote, mikroporige, metallorganische Schicht, die im AlphaPrep-Verfahren erzeugt wird. Diese chemische Vorbehandlung wird standardmäßig als Haftvermittler vor dem Laminierungsprozeß der einzelnen Leiterbahnlagen in der Multilayerplatinenherstellung eingesetzt.

In **Fig. 6** ist die Intensität I des CO₂-Laserstrahls 6 über den Strahlquerschnitt aufgetragen. Der Fokusdurchmesser D des CO₂-Laserstrahls 6 ist definiert durch den Abfall der maximalen Intensität I₀ auf 1/e²*I₀. Durch die weitere Schicht 5 ist die CO₂-Laserstrahlungsabsorption der ersten Kupferschicht 2 erhöht. Entsprechend reduziert sich die zum Abtragen der ersten Kupferschicht 2 erforderliche Schwellenintensität I_{S} der CO₂-Laserstrahlung, so daß die beschichtete erste Kupferschicht mittels des CO₂-Laserstrahls 6, dessen Intensität zum Abtragen der unbeschichteten ersten Kupferschicht 2 nicht ausreichen würde, dennoch abgetragen wird.

Der Lochdurchmesser wird dabei nicht durch den Fokusdurchmesser D des CO₂-Laserstrahls 6, sondern durch den Strahldurchmesser d bestimmt, innerhalb dem die Intensität höher als die Schwellenintensität I_{S} des Kupfers ist. Für Durchmesser größer als dieser Strahldurchmesser d wirkt die erste Kupferschicht 2 als Blende für den Laserstrahl 6.

Im gezeigten Ausführungsbeispiel sind der Strahldurchmesser d und damit auch der Lochdurchmesser kleiner als der Fokusdurchmesser D. Mit einem Fokusdurchmesser von ca. 90 *µ*m können Löcher mit einem Durchmesser von ca. 50 *µ*m gebohrt werden. Um Löcher mit einem Durchmesser von 90-100 µm zu bohren, kann auch mit einem defokussierten Laserstrahl mit einem Fokusdurchmesser von 150 µm auf der Kupferoberfläche gearbeitet werden. Die zum Kupferbohren erforderliche Energie beträgt in diesem Fall 22 mJ.

## Patentansprüche

1. Verfahren zum Herstellen von Löchern (7) in der die Außenseite einer Mehrlagenleiterplatte (1) bildenden ersten Kupferschicht (2) und in einer Dielektrikumschicht (4), welche die erste Kupferschicht (2) von einer zweiten Kupferschicht (3) trennt, mittels Laserstrahlung, wobei zur Abtragung der Dielektrikumschicht (4) ein CO₂-Laserstrahl (6) verwendet wird und wobei entweder die Intensität des CO₂-Laserstrahls (6) höher als die zum Abtragen der ersten Kupferschicht (2) erforderliche Schwellenintensität (Iₛ) gewählt wird und das Loch (7) in der ersten Kupferschicht (2) und in der Dielektrikumschicht (4) mit dem gleichen CO₂-Laserstrahl (6) erzeugt wird oder wobei die Außenseite der ersten Kupferschicht (2) mit einer Schicht (5), deren CO₂-Laserstrahlungsabsorption größer als die CO₂-Laserstrahlungsabsorption der Außenseite der ersten Kupferschicht (2) ist, oder mit einer die CO₂-Laserstrahlungsabsorption erhöhenden Oberflächenbeschaffenheit versehen wird und dann ein Loch (7) in der ersten Kupferschicht (2) und in der Dielektrikumschicht (4) mit dem gleichen CO₂-Laserstrahl (6) erzeugt wird,
**dadurch gekennzeichnet,**
**daß** die Schwellenintensität (I_{S}) des CO₂-Laserstrahls (6) nur innerhalb eines Strahldurchmessers (d) kleiner als der Fokusdurchmesser (D) des CO₂-Laserstrahls (6) überschritten wird.

2. Verfahren nach Anspruch 1, **dadurch gekennzeichnet, daß** die Schicht (5), vorzugsweise vollflächig, auf der Außenseite der ersten Kupferschicht (2) abgeschieden wird.

3. Verfahren nach Anspruch 1 oder 2, **dadurch gekennzeichnet, daß** die Außenseite der ersten Kupferschicht (2) aufgeraut, vorzugweise angeätzt wird.

4. Verfahren nach einem der Ansprüche 1 bis 3, **dadurch gekennzeichnet, daß** die Dielektrikumschicht (4) bis zur zweiten Kupferschicht (3) abgetragen wird.

## Claims

1. Method for producing holes (7) in the first copper layer (2), which forms the outer side of a multi-layer conductor plate (1), and in a dielectric layer (4) which separates the first copper layer (2) from a second copper layer (3), by means of laser radiation, a CO₂ laser beam (6) being used to erode the dielectric layer (4) and the intensity of the CO₂ laser beam (6) being selected so as to be higher than the threshold intensity (Iₛ) necessary to erode the first copper layer (2) and the hole (7) being produced in the first copper layer (2) and in the dielectric layer (4) with the same CO₂ laser beam (6), or the outer side of the first copper layer (2) having a layer (5) whose CO₂ laser radiation absorption level is greater than the CO₂ laser radiation absorption level of the outer side of the first copper layer (2), or being provided with surface characteristics which increase the CO₂ laser radiation absorption level and a hole (7) then being produced in the first copper layer (2) and in the dielectric layer (4) with the same CO₂ laser beam (6),
**characterised in that**
the threshold intensity (Iₛ) of the CO₂ laser beam (6) is exceeded only within a beam diameter (d) smaller than the focal diameter (D) of the CO₂ laser beam (6).

2. Method according to claim 1, **characterised in that** the layer (5) is deposited, preferably over the entire face, on the outer side of the first copper layer (2).

3. Method according to claim 1 or 2, **characterised in that** the outer side of the first copper layer (2) is roughened, preferably etched.

4. Method according to any one of claims 1 to 3, **characterised in that** the dielectric layer (4) is removed as far as the second copper layer (3).

## Revendications

1. Procédé pour réaliser des trous (7) dans la première couche de cuivre (2) formant la face extérieure d'une carte à circuit imprimé multicouche (1) et dans une couche de diélectrique (4) qui sépare la première couche de cuivre (2) d'une deuxième couche de cuivre (3), à l'aide d'un rayonnement laser, dans lequel on utilise un rayon laser CO₂ (6) pour enlever la couche de diélectrique (4) et dans lequel soit l'intensité du rayon laser CO₂ (6) est choisie plus élevée que l'intensité seuil (Iₛ) nécessaire pour enlever la première couche de cuivre (2) et le trou (7) est créé dans la première couche de cuivre (2) et dans la couche de diélectrique (4) avec le même rayon laser CO₂ (6), soit la face extérieure de la première couche de cuivre (2) est munie d'une couche (5) dont l'absorption du rayonnement laser CO₂ est supérieure à l'absorption du rayonnement laser CO₂ de la face extérieure de la première couche de cuivre (2), ou munie d'un état de surface augmentant l'absorption du rayonnement laser CO₂, et un trou (7) est ensuite créé dans la première couche de cuivre (2) et dans la couche de diélectrique (4) avec le même rayon laser CO₂,
**caractérisé par le fait**
**que** l'intensité seuil (Iₛ) du rayon laser CO₂ (6) n'est dépassée qu'à l'intérieur d'un diamètre de rayon (d) plus petit que le diamètre de foyer (D) du rayon laser CO₂ (6).

2. Procédé selon la revendication 1, **caractérisé par le fait que** la couche (5) est déposée, de préférence sur toute la surface, sur la face extérieure de la première couche de cuivre (2).

3. Procédé selon la revendication 1 ou 2, **caractérisé par le fait que** la face extérieure de la première couche de cuivre (2) est rendue rugueuse, de préférence décapée.

4. Procédé selon l'une des revendications 1 à 3, **caractérisé par le fait que** la couche de diélectrique (4) est enlevée jusqu'à la deuxième couche de cuivre (3).
